# EUROPÄISCHE PATENTSCHRIFT

(11) **EP 2 870 511 B1**
(45) Veröffentlichungstag und Bekanntmachung des Hinweises auf die Patenterteilung: **21.10.2015**
(21) Anmeldenummer: 12766624.6
(22) Anmeldetag: 18.09.2012
(51) Int. Cl.: G03F 7/00, B29C 33/06

(54) **VERFAHREN ZUM PRÄGEN**
METHOD FOR EMBOSSING
PROCÉDÉ POUR LE GAUFRAGE

(43) Veröffentlichungstag der Anmeldung: 13.05.2015
(73) Patentinhaber: Ev Group E. Thallner GmbH, 4782 St. Florian am Inn (AT)
(72) Erfinder: TREIBLMAYR, Dominik, A-4943 Kirchdorf am Inn (AT)
(74) Vertreter: Schweiger, Johannes
(86) Internationale Anmeldenummer: PCT/EP2012/068355
(87) Internationale Veröffentlichungsnummer: WO 2014/044295

(56) Entgegenhaltungen:
- WO-A1-01/63361
- WO-A1-2004/114017
- WO-A1-2009/137049
- DE-A1-102008 029 058
- US-A1- 2004 149 367
- US-A1- 2007 251 940
- US-A1- 2010 009 137

## Beschreibung

Die vorliegende Erfindung betrifft ein Verfahren zum Prägen einer Struktur in eine auf einem Substrat aufgebrachte Prägemasse gemäß Anspruch 1.

In vielen Industriezweigen, allen voran aber in der Halbleiterindustrie, werden Präge-(Imprint-)Technologien immer bedeutender, um Mikro-und/oder Nanostrukturen mit geringem Aufwand, geringen Kosten und kurzen Prozesszeiten herzustellen.

Bei bekannten Imprint-Technologien handelt es sich um Verfahren, bei welchen ein Stempel durch eine Kraft in eine Prägemasse gedrückt wird, um ein Negativ des Stempels zu erzeugen. Die dabei verwendeten Materialien der Prägemasse können nach dem Prägevorgang durch unterschiedliche chemische und/oder physikalische Prozesse gehärtet werden, so dass die Prägemasse entsprechend aushärtet und nach der Entfernung des Stempels formstabil ist.

Die Aushärtung erfolgt beispielsweise durch Bestrahlung mit UV-Licht, durch Heizen mittels Heizelementen, durch elektrische und/oder magnetische Felder, durch chemische Reaktion mit einem Reagenz etc.

Beim thermischen Aushärten erfolgt das Aufheizen und Abkühlen, insbesondere wiederholt, in einer Kammer, so dass hohe Kosten durch hohen Energie- und Zeitbedarf anfallen.

Aufgabe der vorliegenden Erfindung ist es daher, ein Verfahren und eine Vorrichtung anzugeben, mit welchen eine schnelle, effiziente und kostengünstige Prägung einer, insbesondere thermisch aushärtbaren, Prägemasse ermöglicht wird.

Diese Aufgabe wird mit den Merkmalen des Ansprüchs 1 gelost. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren angegebenen Merkmalen.

Der Erfindung liegt der Gedanke zugrunde, das die Prägemasse aufnehmende Substrat und/oder einen Stempel und/oder eine zwischen dem Substrat und der Prägemasse und/oder zwischen dem Stempel und der Prägemasse angeordnete Heizschicht gemäß Anspruch 1 zum Aushärten der, insbesondere thermisch aushärtbaren, Prägemasse mit Mikrowellen zu bestrahlen. Das Substrat und/oder der Stempel und/oder die Heizschichten werden dabei erfindungsgemäß so gewählt, dass diese durch Mikrowellen heizbar sind. Durch die Bestrahlung mit Mikrowellen ist ein gezieltes (indirektes) Heizen der, insbesondere thermisch aushärtbaren, Prägemasse vorgesehen, so dass eine effiziente Steuerung des Aushärtevorgangs und der vorgesehenen Heiztemperaturen und/oder Heizverläufe ermöglicht wird. Insbesondere ist es erfindungsgemäß denkbar, an dem Substrat und/oder dem Stempel und/oder der Heizschicht, vorzugsweise an der zur Prägemasse abgewandten Seite, Temperatursensoren vorzusehen, um die Steuerung der Mikrowellenbestrahlung anhand der tatsächlich gemessenen Temperatur zu ermöglichen.

Unter thermischer Aushärtbarkeit versteht man die Fähigkeit von Materilaien, nach einer Wärmebehandlung, einen formstabilen Zustand einzunehmen. Darunter fallen vor allem, aber nicht ausschließlich, die Materialien der Materialgruppen Thermoplaste und Duroplaste.

Als weiterer Aspekt der vorliegenden Erfindung ist insbesondere das Trennen/Entformen des Prägestempels von der ausgehärteten Prägemasse mittels Trennmitteln vorgesehen. Dies erfolgt insbesondere in einem separaten Verfahrensschritt und/oder einem, vorzugsweise räumlich getrennten, Vorrichtungsmodul.

Substrat steht im weiteren Sinne für jedes Element, auf welchem eine Prägemasse aufgebracht wird. Bei dem Substrat kann es sich auch um einen Stempel handeln, der mit der Prägemasse bedeckt wird.

In einer vorteilhaften Ausführungsform der Erfindung ist vorgesehen, dass die zur Bestrahlung eingesetzten Mikrowellen elektromagnetische Wellen mit einer Frequenz zwischen 0,01 GHz und 100 GHz, insbesondere zwischen 0,1 GHz und 50 GHz, vorzugsweise zwischen 1 GHz und 10 GHz, noch bevorzugter zwischen 2 GHz und 5 GHz sind. Am meisten bevorzugt ist eine Frequenz von 2,45 GHz, so dass insbesondere vorhandene Mikrowellengeräte für die Bestrahlung verwendbar sind.

Gemäß der Erfindung ist vorgesehen, dass als Heizschicht eine molekulare Dipolverbindung, insbesondere deionisiertes Wasser, verwendet wird. Als molekulare Dipolverbindung kommen Flüssigkeiten, insbesondere organische Substanzen, in Frage. Die molekularen Dipolverbindungen werden auf das Substrat aufgebracht, insbesondere durch Kondensation von in der Atmosphäre vorhandener Feuchtigkeit an der Oberfläche des Substrats. Alternativ kann die Aufbringung eines Flüssigkeits Films auf das Prägesubstrat durch einen geeigneten Beschichtungsprozess erfolgen. Insbesondere ist die Verwendung einer Spincoatinganlage vorgesehen, auf der, vorzugsweise durch einen Abschleuderprozess, die Dicke des Flüssigkeits Films bis auf wenige Monolagen reduziert werden kann. Insbesondere wird eine Schichtdicke für die monokulare Dipolverbindung von weniger als 10 Monolayer, vorzugsweise weniger als 5 Monolayer, noch bevorzugter weniger als 3 Monolayer vorgesehen. Erfindungsgemäß ist die Dicke der molekularen Dipolverbindung insbesondere kleiner als 1 mm, mit Vorzug kleiner als 100 µm, mit größerem Vorzug kleiner als 10 µm, mit größtem Vorzug kleiner als 1 µm, mit allergrößtem Vorzug kleiner als 0.1 µm.

Indem das Substrat eine molare Wärmekapazität zwischen 0.001 J/gK und 100 J/gK, bevorzugter zwischen 0.01 J/gK und 10 J/gK, noch bevorzugter zwischen 0.1 J/gK und 1 J/gK, am bevorzugtesten zwischen 0.7 und 0.8 J/gK aufweist, lässt sich das Aushärten effizienter steuern, ohne dass es zu lokalen Überhitzungen kommt. Wärmekapazitäten bei konstantem Druck oder konstantem Volumen können mit entsprechenden Kalorimetern bestimmt werden.

Die Wärmeleitung des Substrats wird durch Materialauswahl so groß wie möglichgewählt, um die Wärme möglichst schnell an die Umgebung, und damit an die Prägemasse, abzugeben. Das Substrat weist erfindungsgemäß vorzugsweise eine Wärmeleitfähigkeit zwischen 0.10 W/(m*K) und 3000 W/(m*K), mit Vorzug zwischen 1 W/(m*K) und 1000 W/(m*K), mit größerem Vorzug zwischen 10 W/(m*K) und 200 W/(m*K), mit allergrößtem Vorzug zwischen 100 W/(m*K) und 155 W/(m*K).

Es wird die Verwendung organischer Filme als Heizschicht zum Aushärten der Prägemasse mittels Mikrowellenbestrahlung offenbart. Insbesondere organische Filme zumindest überwiegend bestehend aus bipolaren Molekülen, vorzugsweise mit einer hohen Adhäsionswirkung zum Substrat und/oder einer geringen Adhäsionswirkung zum Prägematerial. Hierdurch lässt sich die Prägemasse nach der Aushärtung vom Substrat einfacher entfernen. Durch die hohe Adhäsion zum Substrat wird sichergestellt, dass sich die Heizschicht während der thermischen Belastung durch Mikrowellenbestrahlung nicht vom Substrat trennt.

Es wird ein dotiertes Substrat zum Prägen einer Struktur in eine auf dem Substrat aufgebrachte Prägemasse, insbesondere gemäß dem vorbeschriebenen Verfahren, offenbart. Die Dotierung wird derart gewählt, dass das Substrat nach Dotierung besser durch Mikrowellen eines gewissen Frequenzbereichs erwärmt wird, also besser auf die Mikrowellen anspricht. Dem Fachmann auf dem Gebiet sind alle gängigen Dotierelemente für die entsprechenden Substrate bekannt. Beispielhaft seien die Dotierung mit Phosphor (P), Bor (B), Arsen (As) und Antimon (Sb) in Silizium offenbart.

Vorrichtungsgemäß wird die Erfindung weitergebildet, in dem die Mikrowellenbestrahlungsmittel derart ausgerichtet sind, dass die Wirkung der Mikrowellen senkrecht zur Substratoberfläche ausgerichtet ist, also der Poynting-Vektor der Mikrowellenstrahlen normal auf die Substratoberfläche steht.

In Weiterbildung der Erfindung ist mit Vorteil vorgesehen, dass das Substrat eine Dicke zwischen 10000 µm und 0.1 µm, bevorzugt zwischen 1000µm und 1 µm, noch bevorzugter zwischen 100µm und 10µm und/oder einem Durchmesser von mehr als 1" aufweiset. Bevorzugte Durchmesser in der Halbleiterindustrie sind 1', 2", 3", 4", 5", 6", 8", 12" oder 18". Die Erfindung ist allerdings nicht auf ein Substrat mit einem genormten Durchmesser beschränkt. Durch die geringe Dicke des Substrats ist eine sehr schnelle Erwärmung des Substrats unter geringem Energieverbrauch möglich. Durch die vergleichsweise großen Durchmesser kann mit einem einzigen Verfahrensablauf eine großflächige Prägemasse geprägt werden.

Soweit Verfahrensmerkmale beschrieben werden, sollen diese auch als Vorrichtungsmerkmale offenbart gelten und umgekehrt.

Weitere Merkmale und Einzelheiten der Erfindung ergeben sich aus den Ansprüchen, der nachfolgenden Figurenbeschreibung und den Figuren. Diese zeigen in:
- Fig. 1a: eine Kombination von einem Substrat und einem (Präge-)Stempel,
- Fig. 1b: zeigt eine erfindungsgemäße erste Ausführungsform von einem Substrat mit einer Heizschicht und einem Stempel,
- Fig. 1c: zeigt eine erfindungsgemäße zweite Ausführungsform von einem Substrat und einem Stempel mit einer Heizschicht,
- Fig. 1d: zeigt eine erfindungsgemäße dritte Ausführungsform von einem Substrat mit Heizschicht und einem Stempel mit Heizschicht,
- Fig. 2a: zeigt einen ersten erfindungsgemäßen Schritt der Belackung eines Substrats mit einer Prägemasse,
- Fig. 2b: zeigt einen zweiten erfindungsgemäßen Schritt der Prägung,
- Fig. 2c: zeigt einen erfindungsgemäßen dritten Schritt der Bestrahlung des Substrats und/oder Stempels und/oder Heizschicht zur Erwärmung und
- Fig. 2d: zeigt eine erfindungsgemäßen vierten Schritt der Entformung der Prägemasse.

In den Figuren sind gleiche oder gleichwirkende Bauteile/Merkmale mit identischen Bezugszeichen gekennzeichnet.

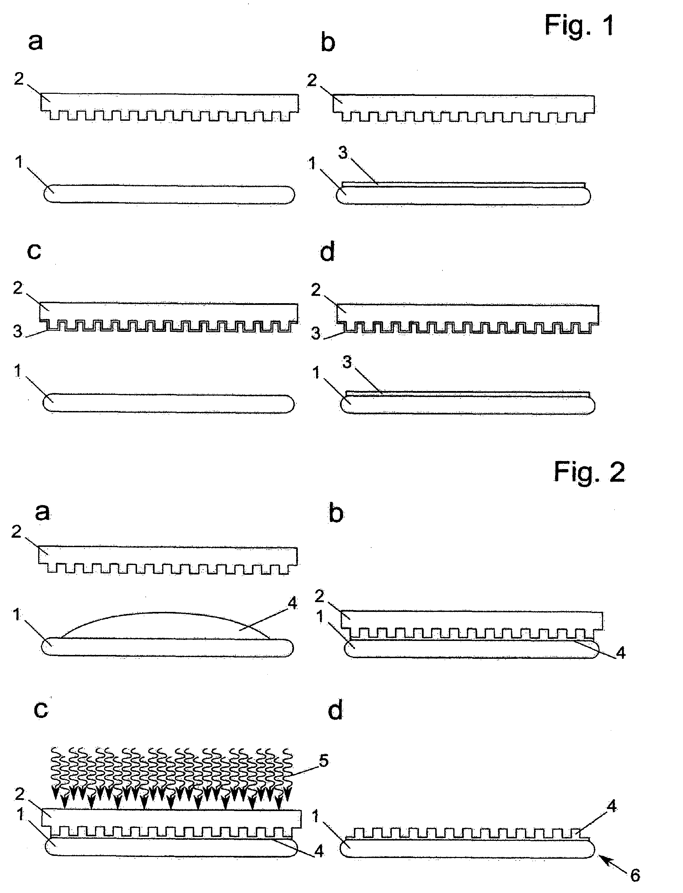

In Figur 1a ist ein Substrat 1 zur Aufnahme einer Prägemasse 4 zum Herstellen eines mit ausgehärteten Mikro- und/oder Nanostrukturen versehenen Negativs 6 eines Prägestempels 2 gezeigt, wobei durch entsprechende Materialauswahl insbesondere der Prägestempel 2 und/oder das Substrat 1 als Heizschicht dienen.

In der in Figur 1b gezeigten Ausführungsform ist eine Heizschicht 3 auf der dem Prägestempel 2 zugewandten Flachseite des Substrats 1 aufgebracht.

In der in Figur 1c gezeigten Ausführungsform ist die Heizschicht 3 auf einer strukturierten Prägeseite des Prägestempels 2 aufgebracht. Hierdurch wird die Heizfläche und damit die Heizleistung deutlich vergrößert.

Eine weitere Verbesserung der Heizleistung wird erreicht, indem gemäß Figur 1d die Heizflächen 3 aus den Ausführungen gemäß Figuren 1b und 1c kombiniert werden.

Der Ablauf des erfindungsgemäßen Verfahrens ist einer Ausfürhungsform in den Figuren 2a bis 2b dargestellt. Im in Fugur 2a gezeigten Schritt wird die Prägemasse 4 auf das Substrat 1 aufgebracht und der Prägestempel gegenüber dem Substrat positioniert und exakt ausgerichtet.

Figur 2b zeigt das Ende des Prägeschritts. Der Prägestempel 2 und das Substrat 1 werden parallel ausgerichtet aufeinander zu bewegt, wobei insbesondere ein Keilfehlerausgleich stattfindet.

Während oder nach erfolgter Annäherung wird die Heizsschicht 3 (in Figuren 2a bis 2d nicht gezeigt) mittels Mikrowellen 5 von einer nicht gezeigten Mikrowellenerzeugungseinrichtung aufgeheizt, um die Prägemasse 4 durch Wärmeleitung zu erwämren und auszuhärten.

Nach erfolgter Aushärtung wird der Prägestempel 2 durch Trennmittel zerstörungsfrei von der ausgehärteten Prägemasse 4 entformt, so dass ein Negativ 6 entsteht.

### Bezugszeichenliste

1 Substrat
2 Stempel
3 Heizschicht
4 Prägemasse
5 Mikrowellen
6 Negativ

## Patentansprüche

1. Verfahren zum Prägen einer Struktur in eine auf einem Substrat (1) aufgebrachte Prägemasse (4) mit folgenden Verfahrensschritten, insbesondere folgendem Ablauf:
• Prägen der Prägemasse (4) durch einen Prägestempel (2),
• Aushärten der Prägemasse (4),
**dadurch gekennzeichnet,**
**dass** zumindest das Substrat (1) und/oder der Prägestempel (2) und/oder mindestens eine zwischen dem Substrat (1) und der Prägemasse (4) und/oder zwischen dem Prägestempel (2) und der Prägemasse (4) als Flüssigkeitsfilm aufgebrachte Heizschicht (3) in Form einer molekularen Dipolverbindung zum Aushärten der Prägemasse (4) zumindest zeitweise mittels Mikrowellen bestrahlt werden.

2. Verfahren nach Anspruch 1,
**dadurch gekennzeichnet,**
**dass** die zur Bestrahlung eingesetzten Mikrowellen elektromagnetische Wellen mit einer Frequenz zwischen 0,01 GHz und 100 GHz, insbesondere zwischen 0,1 und 50 GHz, vorzugsweise zwischen 1 und 10 GHz, noch bevorzugter zwischen 2 und 5 GHz, am bevorzugtesten von etwa 2,45 GHz, sind.

3. Verfahren nach einem der vorhergehenden Ansprüche,
**dadurch gekennzeichnet,**
**dass** als Heizschicht (3) deionisiertes Wasser verwendet wird.

4. Verfahren nach einem der vorhergehenden Ansprüche,
**dadurch gekennzeichnet,**
**dass** das Substrat (1) eine molare Wärmekapazität zwischen 0.001 J/gK und 100 J/gK, bevorzugter zwischen 0.01 J/gK und 10 J/gK, noch bevorzugter zwischen 0.1 J/gK und 1 J/gK, am bevorzugtesten zwischen 0.7 und 0.8 J/gK aufweist.

5. Verfahren nach einem der vorhergehenden Ansprüche,
**dadurch gekennzeichnet,**
**dass** das Substrat (1) eine Dicke zwischen 10000 µm und 0.1 µm, bevorzugt zwischen 1000µm und 1µm, noch bevorzugter zwischen 100µm und 10µm und/oder einen Durchmesser von mehr als 1" aufweist.

## Claims

1. Process for embossing a structure in an embossing material (4), applied on a substrate (1), with the following process steps, in particular the following sequence:
• Embossing the embossing material (4) by an embossing die (2),
• Hardening the embossing material (4),
**characterized in that** at least the substrate (1) and/or the embossing die (2) and/or at least one heating layer (3) as applied liquid film in form of a molecular dipolar compound arranged between the substrate (1) and the embossing material (4) and/or between the embossing die (2) and the embossing material (4) are at least at times irradiated by means of microwaves for hardening the embossing material (4).

2. Process according to Claim 1, wherein the microwaves used for irradiation are electromagnetic waves with a frequency of between 0.01 GHz and 100 GHz, in particular between 0.1 and 50 GHz, preferably between 1 and 10 GHz, even more preferably between 2 and 5 GHz, and most preferably from about 2.45 GHz.

3. Process according to one of the preceding claims, wherein as a heating layer (3) deionized water is used.

4. Process according to one of the preceding claims, wherein the substrate (1) has a molar heating capacity of between 0.001 J/gK and 100 J/gK, more preferably between 0.01 J/gK and 10 J/gK, even more preferably between 0.1 J/gK and 1 J/gK, and most preferably between 0.7 and 0.8 J/gK.

5. Process according to one of the preceding claims, wherein the substrate (1) has a thickness of between 10,000 µm and 0.1 µm, preferably between 1,000 µm and 1 µm, and even more preferably between 100 µm and 10 µm, and/or it has a diameter of more than 1".

## Revendications

1. Procédé pour le gaufrage d'une structure dans une masse de gaufrage (4) appliquée sur un substrat (1), avec les étapes suivantes du procédé, en particulier le déroulement suivant :
- le gaufrage de la masse de gaufrage (4) grâce à un poinçon de gaufrage (2),
- le durcissement de la masse de gaufrage (4),
**caractérisé en ce que**
au moins le substrat (1) et/ou le poinçon de gaufrage (2) et/ou au moins une couche chauffage (3) appliquée en tant que pellicule liquide sous la forme d'une liaison moléculaire dipolaire entre le substrat (1) et la masse de gaufrage (4) et/ou entre le poinçon de gaufrage (2) et la masse de gaufrage (4) sont irradiés au moins partiellement au moyen de micro-ondes en vue du durcissement de la masse de gaufrage (4).

2. Procédé selon la revendication 1, **caractérisé en ce que** les micro-ondes utilisées pour l'irradiation sont des ondes électromagnétiques avec une fréquence comprise entre 0,01 GHz et 100 GHz, en particulier entre 0,1 et 50 GHz, de préférence entre 1 et 10 GHz, de manière davantage préférée entre 2 et 5 GHz, de manière tout particulièrement préférée de près de 2,45 GHz.

3. Procédé selon l'une des revendications précédentes, **caractérisé en ce que** l'on utilise de l'eau déionisée en tant que couche chauffante (3).

4. Procédé selon l'une des revendications précédentes, **caractérisé en ce que** le substrat (1) présente une capacité thermique molaire comprise entre 0,001 J/gK et 100 J/gK, de préférence entre 0,01 J/gK et 10 J/gK, de manière davantage préférée entre 0,1 J/gK et 1 J/gK, de manière tout particulièrement préférée entre 0,7 et 0,8 J/Gk.

5. Procédé selon l'une des revendications précédentes, **caractérisé en ce que** le substrat (1) présente une épaisseur comprise entre 10 000 µm et 0,1 µm, de préférence entre 1000 µm et 1 µm, de manière davantage préférée entre 100 µm et 10 µm et/ou un diamètre de plus de 1",
